Europäisches Patentamt

European Patent Office

Office européen des brevets

(19)

(11) Veröffentlichungsnummer: **0 073 946**

**A2**

# (12) EUROPÄISCHE PATENTANMELDUNG

(21) Anmeldenummer: **82107302.0**

(22) Anmeldetag: **11.08.82**

(51) Int. Cl.³: **G 06 F 11/26**

(30) Priorität: **07.09.81 DE 3135368**

(43) Veröffentlichungstag der Anmeldung:
**16.03.83 Patentblatt 83/11**

(84) Benannte Vertragsstaaten:
**BE DE FR GB IT NL**

(71) Anmelder: **SIEMENS AKTIENGESELLSCHAFT**
**Berlin und München Wittelsbacherplatz 2**
**D-8000 München 2(DE)**

(72) Erfinder: **Pfleiderer, Hans-Jörg, Dr.**
**Franz-Krinninger-Weg 23**
**D-8011 Zorneding(DE)**

(72) Erfinder: **Grassl, Gerhard, Dipl.-Ing.**
**Obere Bahnhofstrasse 12**
**D-8011 Zorneding(DE)**

(54) **Verfahren und Anordnung zur Funktionsprüfung einer programmierbaren Logikanordnung.**

(57) Die Erfindung bezieht sich auf die Funktionsprüfung einer programmierbaren Logikanordung, bei der Eingangsleitungen (EL1), Produkttermleitungen (PT1) und Masseleitungen (M1) zu einer UND-Ebene (1) und Ausgangsleitungen (AL1), Produkttermleitungen (PT1) und Masseleitungen (ML1) zu einer ODER-Ebene (2) zusammengefaßt sind. Angestrebt wird eine einfache Methode der Funktionsprüfung, die jeden eventuell vorhandenen Fehler erkennen läßt. Das wird erfindungsgemäß mit einem Testdatengeber (8) erreicht, der Bitmuster 0,0...0; 1,0...0; 0,1...0; 0,0...1 erzeugt und an die Eingangsleitungen (EL1...ELn) legt, sowie mit einem Schieberegister (3), das die Produkttermleitungen (PT1) einzeln oder gruppenweise nacheinander sensibilisiert, d. h. von einem Massepotential freischaltet. Die an den Ausgangsleitungen (AL1) auftretenden Bitmuster werden einem Testdatenauswerter (9) zugeführt. Der Anwendungsbereich unfaßt Logikschaltungen der Datenverarbeitungstechnik.

FIG1

**0073946**

**Verfahren und Anordnung zur Funktionsprüfung einer programmierbaren Logikanordnung**

Die Erfindung bezieht sich auf ein Verfahren zur Funktionsprüfung einer programmierbaren Logikanordnung nach dem Oberbegriff des Anspruchs 1 sowie auf eine Anordnung zur Durchführung des Verfahrens.

Eine programmierbare Logikanordnung (PLA) dieser Art ist beispielsweise der deutschen Patentschrift 25 19 178 entnehmbar. Wie aus dem Aufsatz "Random Patterns Within a Structured Sequential Logic Design" von T.W. Williams und E.B. Eichelberger, abgedruckt in dem Digest of Papers, 1977 Semiconductor Test Symposium, Seiten 19 bis 27, insbesondere Seiten 24 und 25 und Fig. 9, hervorgeht, wird eine Funktionsprüfung des PLA in der Weise durchgeführt, daß eine Vielzahl von Bitmustern an seine Eingänge gelegt und die an den Ausgängen auftretenden Ausgangs-Bitmuster bezüglich etwaiger Abweichungen von Soll-Mustern ausgewertet werden. Dabei tritt jedoch bei Verwendung von Pseudo-Zufallsmustern, die durch einfache Testdatengeneratoren erzeugt werden können, der Nachteil auf, daß bei größeren PLA's mit zahlreichen Ein- und Ausgängen auch bei Verwendung von etwa 1000 Bitmustern nur etwa 60 % der möglicherweise vorhandenen Schaltungsfehler entdeckt werden können. Um sämtliche Fehler aufzufinden, ist ein Testdatengenerator erforderlich, der in Abhängigkeit von der zu prüfenden PLA-Schaltung speziell selektierte Bitmuster aussendet. Dabei ist jedoch die Auswahl der Bitmuster aufwendig und zeitraubend, und die hierfür erforderlichen Testdatengeneratoren sind sehr komplex.

St 1 Hub / 02.09.1981

Der vorliegenden Erfindung liegt die Aufgabe zugrunde, ein einfaches Verfahren anzugeben, mit dem ein PLA vollständig auf seine Funktionsfähigkeit überprüft werden kann. Das wird erfindungsgemäß durch eine Ausbildung des Verfahrens nach dem kennzeichnenden Teil des Anspruchs 1 erreicht.

Der mit dem Verfahren nach der Erfindung erzielbare Vorteil besteht insbesondere darin, daß jeder einzelne Transistor des PLA auf seine Funktionsfähigkeit kontrolliert wird. Darüber hinaus kann dieses Verfahren durch einfache Schaltungen mit geringem Platzbedarf realisiert werden, so daß damit eine selbsttätige Prüfung der Schaltung effektiv möglich ist.

Der Anspruch 2 ist auf eine Weiterbildung des Verfahrens nach Anspruch 1 gerichtet, während die Ansprüche 3 bis 9 eine Anordnung zur Durchführung des Verfahrens nach der Erfindung und bevorzugte Weiterbildungen und Ausgestaltungen derselben betreffen.

Die Erfindung wird nachfolgend anhand der Zeichnung näher erläutert. Dabei zeigt:

Fig. 1  eine Schaltungsanordnung zur Durchführung des erfindungsgemäßen Verfahrens,

Fig. 2  Spannungs-Zeit-Diagramme zur Erläuterung von Fig. 1,

Fig. 3  eine Teilschaltung von Fig. 1,

Fig. 4  die Weiterbildung einer Teilschaltung von Fig. 1,

Fig. 5  die Weiterbildung einer anderen Teilschaltung von Fig. 1 und

Fig. 6  eine Alternative zu der Weiterbildung nach Fig.5.

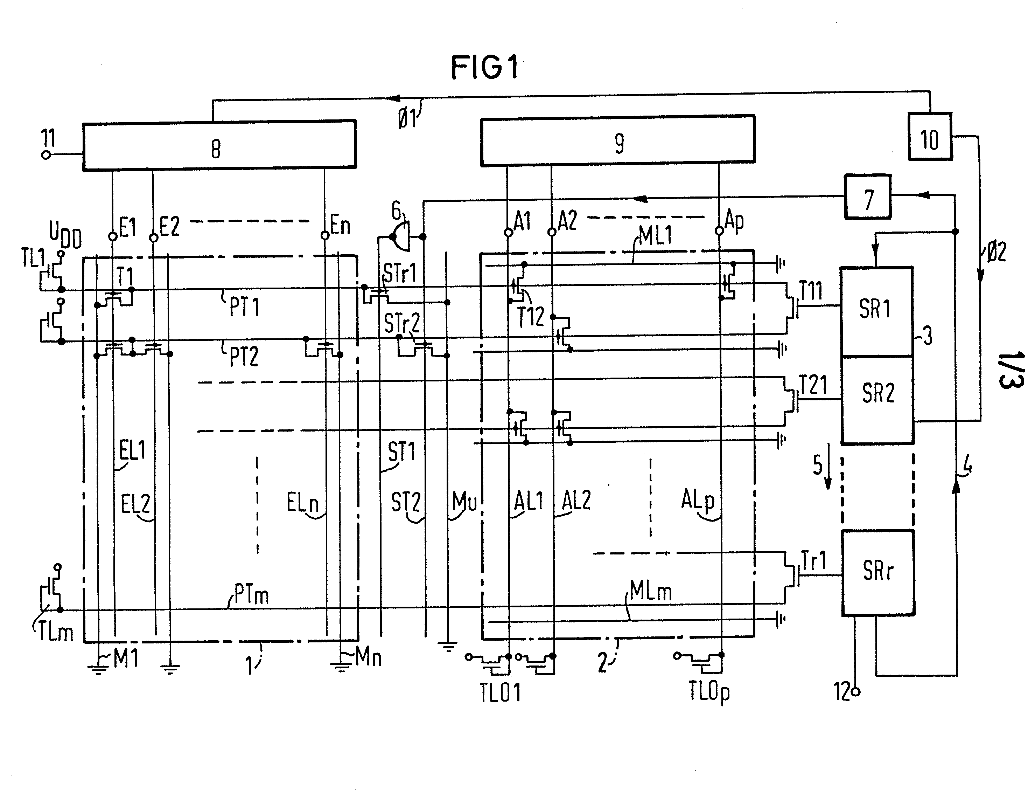

In Fig. 1 ist ein PLA dargestellt, dessen UND-Ebene mit 1 und dessen ODER-Ebene mit 2 bezeichnet ist. Die Eingänge E1 bis En sind mit vertikalen Eingangsleitungen EL1 bis ELn der UND-Ebene verbunden, neben denen Masseleitungen M1 bis Mn angeordnet sind. Horizontale Ausgangsleitungen PT1 bis PTm von 1 werden auch als Produkttermleitungen bezeichnet. An jeder Kreuzungsstelle von einer Eingangsleitung und einer Produkttermleitung kann ein Feldeffekt-Schalttransistor, z. B. T1, vorgesehen sein, dessen Gate mit der betreffenden Eingangsleitung, z. B. EL1, beschaltet ist und dessen Source-Drain-Schaltstrecke die zugeordnete Masseleitung, z. B. M1, mit der an der Kreuzungsstelle befindlichen Produkttermleitung, z. B. PT1, verbindet. Die Kreuzungsstellen von EL2 und PT1 und von ELn und PT1 sind nach Fig. 1 nicht mit Schalttransistoren besetzt.

Die Produkttermleitungen PT1 bis PTn sind an ihrem linken Ende jeweils mit einem als Lastelement geschalteten Transistor TL1 bis TLm versehen, dessen Gate mit seinem Sourceanschluß verbunden ist und dessen Drainanschluß auf der Versorgungsspannung $U_{DD}$ liegt. Die Leitungen PT1 bis PTn stellen gleichzeitig die Eingangsleitungen für die ODER-Ebene 2 dar und sind an ihren rechten Enden jeweils über einen Schalttransistor T11 bis Tr1 paarweise miteinander verbunden. Die Gates dieser Transistoren liegen an den Ausgängen der einzelnen Stufen eines Schieberegisters 3, das über eine Leitung 4 rückgekoppelt ist. Die Verschieberichtung ist durch einen Pfeil 5 angedeutet. Neben den Leitungen PT1 bis PTm sind in der ODER-Ebene 2 Masseleitungen ML1 bis MLm vorgesehen, während in vertikaler Richtung Ausgangsleitungen AL1 bis ALp verlaufen. Die Ausgänge des PLA sind mit A1 bis Ap bezeichnet. An den Kreuzungsstellen der Produkttermleitungen, z. B. PT1, mit den Ausgangsleitungen, z. B. AL1, können Schalttransistoren, z. B. T12, vorgesehen sein, deren Gates dann mit der betreffenden horizontalen Leitung, z. B. PT1 verbunden sind und deren
Source-Drain-Schaltstrecken die jeweilige Masseleitung,
z. B. ML1, mit der Ausgangsleitung, z. B. AL1, verbindet.
An der Kreuzungsstelle von PT1 und AL2 ist beispielsweise
kein Schalttransistor vorgesehen. Die unteren Enden der
Ausgangsleitungen AL1 bis ALp sind als Lastelemente geschaltete Transistoren TL01 bis TL0p angeordnet, deren
Gates mit ihren Sourceanschlüssen beschaltet sind und
deren Drainanschlüsse auf der Versorgungsspannung $U_{DD}$
liegen.

Zwischen den Ebenen 1 und 2 sind Schaltungsteile einer
Auswahlschaltung vorgesehen, die im einzelnen aus einer
Masseleitung Mu, zwei Steuerleitungen St1 und Str2 und
einer Reihe von Schalttransistoren, z. B. STr1, bestehen,
welche jeweils an den Kreuzungsstellen von PT1, PT3 usw.
und ST1 sowie an den Kreuzungsstellen von PT2, PT4 usw.
und ST2 liegen. Ihre Gates sind mit der jeweiligen Steuerleitung verbunden, während ihre Source-Drain-Schaltstrecken die Masseleitung Mu mit der betreffenden Produkttermleitung PT1 bis PTm verbinden. Die Steuerleitungen
ST1 und ST2 liegen am Ausgang bzw. am Eingang eines
Inverters 6, dessen Eingang weiterhin mit dem Ausgang
eines D-Flipflops 7 beschaltet ist. Der Eingang von 7
ist mit der Leitung 4 verbunden.

Die Eingänge E1 bis En des PLA sind mit entsprechenden
Ausgängen eines Testdatengenerators 8 verbunden, während
die Ausgänge A1 bis Ap an die Eingänge eines Testdatenauswerters 9 geführt sind. Ein Taktimpulsgenerator 10
führt dem Testdatengenerator 8 Taktimpulse Ø1 und dem
Schieberegister 3 Taktimpulse Ø2 zu.

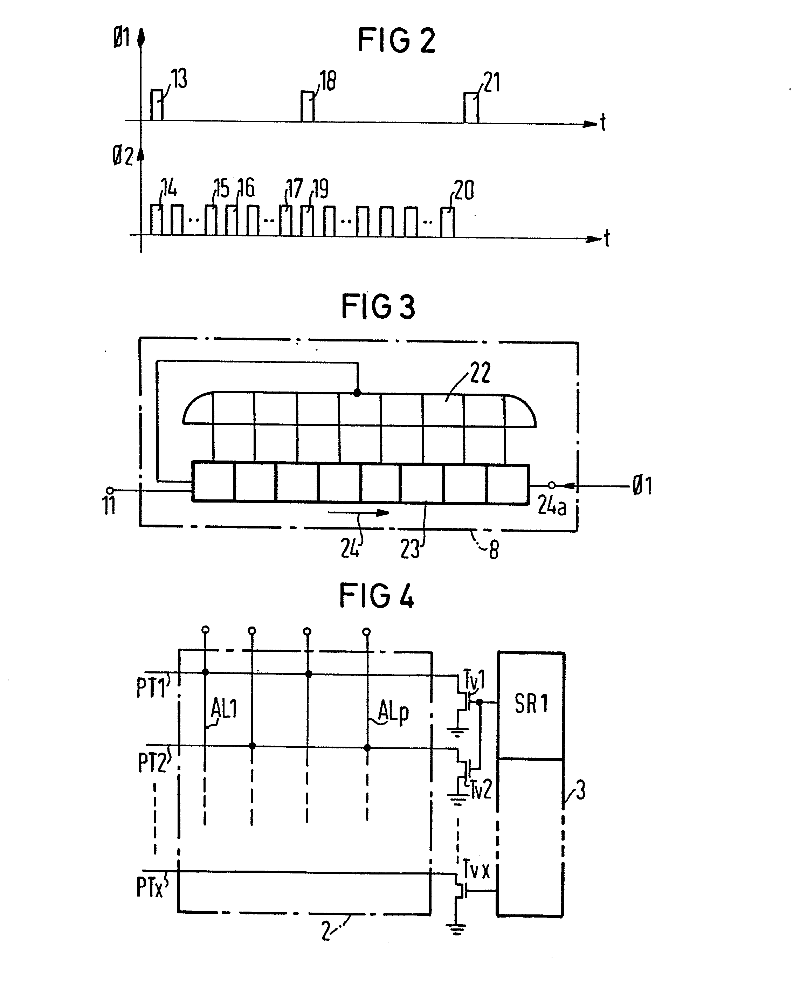

Zu Beginn des Prüfvorgangs sei der Testdatengenerator 8
über einen Reset-Eingang 11 so eingestellt, daß beim
Auftreten eines Taktimpulses 13 von Ø1 (Fig. 2) an
allen Eingängen E1 bis En "0" anliegt. Gleichzeitig
sei das Schieberegister 3 über einen Reset-Eingang 12
so eingestellt, daß beim Auftreten eines Taktimpulses 14
von Ø2 (Fig. 2) am Ausgang der ersten Stufe SR1 eine
"0" liegt, an den Ausgängen aller anderen Stufen SR2...
SRr aber jeweils eine "1". Am Ausgang des D-Flipflop 7
liegt eine "1" und am Ausgang des Inverters 6 eine "0".
Damit ist T11 gesperrt, PT2 liegt über STr 2 an Masse
und PT1 ist sensibilisiert, d. h. im Bereich der ODER-
Ebene 2 als einzige Produkttermleitung nicht auf Masse
gelegt. Letztere Bedingung gilt, weil sämtliche anderen
Produkttermleitungen entweder über den Ein- oder Ausgang
von 6 und einen dadurch leitenden Steuertransistor direkt
auf Masse gelegt sind oder über die leitenden Transistoren T21...Tr1 mit der jeweils anderen Produkttermleitung des Paares verbunden und somit indirekt auf
Masse gelegt sind. Durch das Bitmuster 0,0,...0 an den
Eingängen E1...En bleibt PT1 auf "1", so daß an jedem
der Ausgänge A1...Ap eine "1" auftritt, wenn an der
Kreuzungsstelle von der zu ihm führenden Ausgangsleitung und PT1 ein Schalttransistor fehlt. Ist ein
solcher vorhanden, so gibt der betreffende Ausgang eine
"0" ab. Durch die weiteren Taktimpulse von Ø2 bis einschließlich des Taktimpulses 15 werden nacheinander
andere Ausgänge von 3 mit der "0" belegt, so daß die
dritte, fünfte usw. Produkttermleitung sensibilisiert
wird. Der Taktimpuls 16 von Ø2 legt dann eine "0" an
den Eingang von 7, so daß die Signale auf den Steuerleitungen ST1 und ST2 miteinander vertauscht werden.
Damit wird zunächst PT2 sensibilisiert und mit den
folgenden Taktimpulsen bis einschließlich dem Taktimpuls 17, sodann die Produkttermleitungen PT2, PT4 usw.
sensibilisiert.

Bei diesem ersten Verfahrensschritt werden also an den Ausgängen A1 bis Ap nacheinander m Bitmuster erhalten, die jeweils angeben, an welchen Stellen der einzelnen m Produkttermleitungen in der ODER-Ebene 2 Transistoren, z. B. T12, angeordnet sind.

Es folgt ein zweiter Verfahrensschritt, der durch einen Taktimpuls 18 von Ø1 eingeleitet wird. Hierdurch wird E1...En ein Bitmuster zugeführt, das nur für E1 eine "1" aufweist, während alle anderen Eingänge mit "0" belegt sind. Der Taktimpuls 19 von Ø2 sensibilisiert wieder PT1, so daß die Ausgangssignale an A1 bis Ap nunmehr von dem Vorhandensein oder Nichtvorhandensein des Transistors T1 in 1 abhängen. Im ersten Fall liegt PT1 auf "0", so daß sämtliche Ausgangssignale "1" sind, im letzteren Fall liegt PT1 auf "1", so daß sämtliche Transistoren an Kreuzungsstellen von PT1 und AL1... ALp jeweils zu einer "0" an den betreffenden Ausgängen führen. Alle weiteren Taktimpulse von Ø2 bis einschließlich dem Taktimpuls 20 führen wieder zur schrittweisen Sensibilisierung aller übrigen Produkttermleitungen PT2 bis PTm, so daß hierbei alle Kreuzungsstellen von EL1 und PT2 bis PTm nacheinander auf die Funktionsfähigkeit der an ihnen gegebenenfalls vorgesehenen Schalttransistoren untersucht werden. Da die Testergebnisse jeweils über die ODER-Ebene 2 an die Ausgänge A1...Ap übertragen werden, wird auch gleichzeitig diese Ebene getestet.

Mit dem Auftreten des nächsten Taktimpulses 21 von Ø1 wird dann in einem weiteren Verfahrensschritt das Bitmuster 0,1,00...0 an die Eingänge E1...En gelegt, wobei der bereits beschriebene Ansteuerzyklus der Leitungen PT1 bis PTm dazu führt, daß nunmehr alle Kreuzungsstellen von EL2 mit PT1...PTm nacheinander auf das Vorhandensein von funktionsfähigen Transistoren untersucht werden.

In weiteren Schritten werden dann die Kreuzungsstellen
der weiteren Eingangsleitungen untersucht, so daß schließlich alle in der UND-Ebene 1 vorhandenen Transistoren,
z. B. T1, einzeln einem Funktionsfähigkeitstest unterworfen worden sind. Die Testergebnisse werden dabei jeweils über die ODER-Ebene 2 übertragen.

Der Testdatenauswerter 9 nimmt die abgegebenen Bitmuster
auf, verarbeitet sie und stellt fest, ob wenigstens eine
Abweichung von einem Sollwert vorliegt oder nicht. Dies
kann beispielsweise mittels eines Signaturregisters erfolgen, das jedes von A1...Ap abgegebene Bitmuster aufnimmt, um jeweils einen Schritt verschiebt und mit dem
nächsten abgegebenen Bitmuster in einer vorgegebenen
Weise verknüpft. Nachdem alle Bitmuster eingegangen sind,
ergibt sich aus der Summe aller Verarbeitungsvorgänge
ein Ergebniswert, d. h. eine Signatur. Stimmt diese mit
einem vorgegebenen Sollwert überein, so ist das getestete PLA fehlerfrei.

Eine Abwandlung des Verfahrens ist in der Weise möglich,
daß zunächst nur eine Produkttermleitung, z. B. PT1,
sensibilisiert wird und dabei alle vorhandenen Bitmuster
nacheinander an E1...En gelegt werden. Daran schließt
sich die Sensibilisierung von PT2 an, während der
wieder alle Bitmuster nacheinander an E1...En gelegt
werden, usw. Damit wird erreicht, daß alle Kreuzungsstellen von 1 in einzelnen untereinanderliegenden Zeilen
jeweils von links nach rechts nacheinander untersucht
werden.

Ein wesentlicher Vorteil der Anordnung nach Fig. 1 besteht darin, daß durch den aus den Teilen ST1, ST2 usw.
STr1, STr2 usw., Mu und T11, T21...Tr1 bestehende Auswahlschaltung erreicht wird, die Abmessungen der einzelnen Stufen des Schieberegisters 3 auf das Rastermaß der Produkttermleitungen abzustimmen. Durch die Zuordnung jeweils einer Stufe, z. B. SR1, zu zwei Leitungen, z. B. PT1 und PT2, ist es möglich, die Länge von 3 etwa der vertikalen Abmessung von 2 anzugleichen.

Fig. 3 zeigt eine bevorzugte Ausführungsform des Testdatengenerators 8. Danach weist dieser ein von jeder Stufe über ein NOR-Gatter rückgekoppeltes Schieberegister 23 auf, dessen Verschieberichtung mit 24 gekennzeichnet ist. Die Taktimpulse Ø1 werden einem Eingang 24a zugeführt.

Bei großen PLA-Anordnungen können mit Vorteil die in großer Zahl vorhandenen Produkttermleitungen so angeordnet werden, daß jeweils zwei nebeneinanderliegende Produkttermleitungen keine belegten Kreuzungsstellen mit ein und derselben Ausgangsleitung aufweisen. Fig. 4 deutet eine solche Ausführungsform an, bei der die Produkttermleitungen PT1 und PT2 über zwei Transistoren Tv1 und Tv2 von der Stufe SR1 des Schieberegisters 3 gleichzeitig sensibilisiert werden, d. h. beim Auftreten einer "0" am Ausgang dieser Stufe über die dann gesperrten Transistoren Tv1 und Tv2 von dem Massepotential abgetrennt werden. Alle übrigen Stufen von 3 geben über ihre Ausgänge gleichzeitig eine "1" ab, so daß allen übrigen Produkttermleitungen PTx währenddessen leitende Transistoren Tvx aufweisen und somit auf Masse gelegt sind.

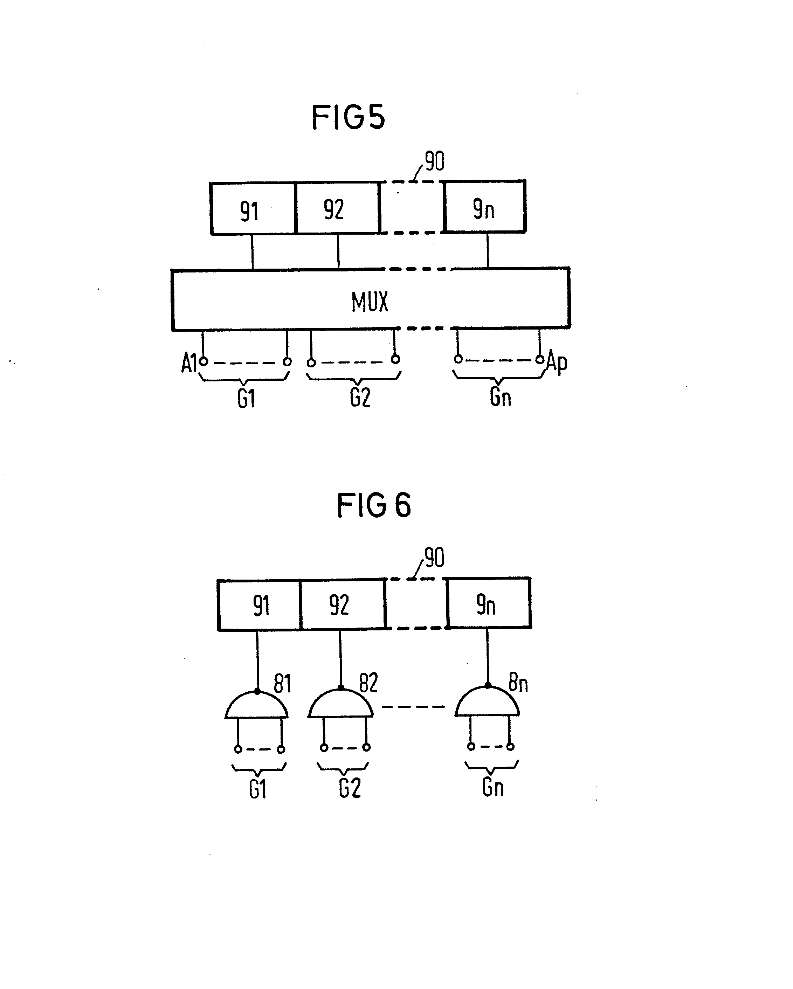

Fig. 5 zeigt eine Weiterbildung der Anordnung nach Fig.1, die einen Multiplexer MUX aufweist, der den Ausgängen A1...Ap nachgeschaltet ist. Weist der Testdatenauswerter ein n-stufiges Signaturregister 90 auf, so können die Ausgänge A1...Ap zu n Gruppen G1 bis Gn zusammengefaßt

**0073946**

werden. Dann schaltet man zunächst die ersten Ausgänge aller Gruppen über den Multiplexer MUX an die n Stufen 91, 92...9n von 90 durch, anschließend die zweiten Ausgänge aller Gruppen usw.

Schließlich besteht eine andere Weiterbildung darin, daß die vorstehend erwähnten n Gruppen G1...Gn von Ausgängen A1...Ap jeweils an die Eingänge von n gruppenspezifischen NAND-Gattern 81,82...8n geführt werden, deren Ausgänge dann mit den Eingängen der n Stufen des Signaturregisters 90 beschaltet sind. Eine Prinzipschaltung hierzu zeigt Fig. 6. Die zu einer Gruppe zusammengefaßten Ausgänge dürfen hierbei jedoch nicht an Ausgangsleitungen liegen, die belegte Kreuzungsstellen mit ein und derselben Produkttermleitung aufweisen.

Durch die Anwendung des Multiplexers MUX oder der NAND-Gatter 81,82...8n wird das Signaturregister 90 in seiner Länge an die Abmessung der ODER-Ebene 2 des PLA in Richtung der Produkttermleitungen angepaßt.

9 Patentansprüche
6 Figuren

Patentansprüche

1. Verfahren zur Funktionsprüfung einer programmierbaren Logikanordnung (PLA), bei der Eingangsleitungen, kreuzende Produkttermleitungen und Masseleitungen zu einer UND-Ebene zusammengefaßt sind, bei der die Produkttermleitungen weiterhin mit kreuzenden Ausgangsleitungen und Masseleitungen zu einer ODER-Ebene zusammengefaßt sind und bei der an selektierten Kreuzungsstellen beider Ebenen Schalttransistoren vorgesehen sind, wobei zunächst eine Folge von Bitmustern an die Eingangsleitungen gelegt wird und in Abhängigkeit von den wenigstens in einer Ebene angeordneten Schalttransistoren Ausgangs-Bitmuster über die Ausgangsleitungen abgeleitet werden, die auf eine Abweichung von einem Soll-Ergebnis untersucht werden, d a d u r c h   g e k e n n - z e i c h n e t ,    daß die Eingangsleitungen (EL1...ELn) einzeln und nacheinander mit einer logischen "1" belegt werden, während alle anderen Eingangsleitungen mit einer logischen "0" beaufschlagt werden, daß die Produkttermleitungen (PT1...PTm) einzeln oder gruppenweise nacheinander von einem Massepotential freigeschaltet werden, während die übrigen Produkttermleitungen bzw. die übrigen Gruppen von solchen auf Massepotential festgehalten werden und daß die an den Ausgangsleitungen (AL1...ALp) auftretenden Bitmuster einem Testdatenauswerter (9) zugeführt werden.

2. Verfahren nach Anspruch 1,    d a d u r c h   g e - k e n n z e i c h n e t ,    daß allen Eingangsleitungen (EL1...ELn) in einem zusätzlichen Verfahrensschritt eine logische "0" zugeführt wird.

3. Anordnung zur Durchführung des Verfahrens nach Anspruch 1 oder 2, d a d u r c h   g e k e n n - z e i c h n e t ,   daß die Eingangsleitungen (EL1... ELn) mit den Ausgängen eines Testdatengenerators (8) beschaltet sind, der zur Erzeugung der Bitmuster 000...0, 100...0, 010...0, 001...0 und 000...1 dient, daß ein Schieberegister (3) vorgesehen ist, dessen Parallelaus- gängen(SR1...SRr) Schaltelemente nachgeordnet sind, die jeweils zur Abschaltung mindestens einer Produkttermleitung (PT1) von einem auf Massepotential liegenden Schaltungspunkt dienen, und daß die Ausgangsleitungen (AL1...ALp) mit einem Testdatenauswerter (9) beschaltet sind.

4. Anordnung nach Anspruch 3, d a d u r c h   g e - k e n n z e i c h n e t ,   daß die Produkttermleitungen (PT1...PTm) jeweils zu Paaren (PT1, PT2) zusammengefaßt sind, wobei die eine Produkttermleitung (PT1) eines jeden Paares über einen ersten Steuertransistor (STr1) und die zweite Produkttermleitung (PT2) des Paares über einen zweiten Steuertransistor (STr2) mit einer der genannten oder einer weiteren Masseleitung (Mu) verbunden sind, daß die ersten Steuertransistoren (STr1) am Ausgang und die zweiten Steuertransistoren (STr2) am Eingang eines Inverters (6) liegen, der über ein Flipflop (7) von einem Ausgang des Schieberegisters (3) steuerbar ist, und daß die beiden Produkttermleitungen (PT1, PT2) jedes Paares über einen Schalttransistor (T11) miteinander verbunden sind, dessen Steuereingang an einem Parallelausgang des Schieberegisters (3) liegt.

5. Anordnung nach Anspruch 3, d a d u r c h   g e - k e n n z e i c h n e t ,   daß der Testdatengenerator (8) ein von jedem Ausgang über ein NOR-Gatter (22) rück- gekoppeltes Schieberegister (23) enthält.

6. Anordnung nach Anspruch 3, d a d u r c h   g e -
k e n n z e i c h n e t ,    daß die Produkttermleitungen
zu Paaren zusammengefaßt sind, wobei die eine Produkttermleitung (PT1) jedes Paares über einen ersten zugeordneten Schalttransistor(Tv1) und die andere Produkttermleitung (PT2) jedes Paares über einen zweiten zugeordneten Schalttransistor (Tv2) mit einem auf Massepotential
liegenden Schaltungspunkt verbunden sind und daß die
Steuereingänge der beiden zugeordneten Schalttransistoren
eines solchen Paares an einem Parallelausgang des Schieberegisters (3) liegen.

7. Anordnung nach Anspruch 3, d a d u r c h   g e -
k e n n z e i c h n e t ,    daß der Testdatenauswerter
aus einem Signaturregister (90) besteht.

8. Anordnung nach Anspruch 3, d a d u r c h   g e -
k e n n z e i c h n e t ,    daß die Ausgänge (A1...Ap)
zu Gruppen (G1...Gn) zusammengefaßt sind, die an gruppenspezifische Ausgänge eines Multiplexers (MUX) durchschaltbar sind, welche mit den Eingängen von gruppenspezifischen Stufen des als Testdatenauswerter dienenden
Signaturregisters (90) beschaltet sind.

9. Anordnung nach Anspruch 3, d a d u r c h   g e -
k e n n z e i c h n e t ,    daß die Ausgänge (A1...Ap)
zu Gruppen (G1...Gn) zusammengefaßt sind, daß alle
Ausgänge einer Gruppe an den Eingängen von gruppenspezifischen NAND-Gattern (81...8n) liegen und daß die Ausgänge
der letzteren mit den Eingängen von gruppenspezifischen
Stufen des als Testdatenauswerter dienenden Signaturregisters (90) beschaltet sind.

FIG1

0073946

1/3

2/3

FIG 2

FIG 3

FIG 4

## FIG 5

## FIG 6